# EUROPÄISCHE PATENTSCHRIFT

(11) **EP 1 341 941 B1**
(45) Veröffentlichungstag und Bekanntmachung des Hinweises auf die Patenterteilung: **07.02.2007**
(21) Anmeldenummer: 01989397.3
(22) Anmeldetag: 05.12.2001
(51) Int. Cl.: C22C 5/06, C22C 9/00, C22C 19/03, H01B 12/00, H01L 39/12

(54) **METALLBAND FÜR EPITAKTISCHE BESCHICHTUNGEN UND VERFAHREN ZU DESSEN HERSTELLUNG**
METAL STRIP FOR EPITAXIAL COATINGS AND METHOD FOR THE PRODUCTION THEREOF
BANDE METALLIQUE POUR REVETEMENT EPITAXIAL ET PROCEDE PERMETTANT DE LA PRODUIRE

(30) Priorität: 07.12.2000 DE 10061399; 07.12.2000 DE 10061398
(43) Veröffentlichungstag der Anmeldung: 10.09.2003
(73) Patentinhaber: Leibniz-Institut für Festkörper- und Werkstoffforschung Dresden e.V., 01069 Dresden (DE)
(72) Erfinder: DE BOER, Bernd, 58762 Altena (DE); HOLZAPFEL, Bernhard, 01731 Kreischa (DE); RISSE, Gunter, 01237 Dresden (DE)
(74) Vertreter: Rauschenbach, Dieter
(86) Internationale Anmeldenummer: PCT/DE2001/004648
(87) Internationale Veröffentlichungsnummer: WO 2002/046108

(56) Entgegenhaltungen:
- EP-A- 0 884 787
- WO-A-99/17307
- DE-A- 10 005 861
- US-A- 3 296 695
- LOCKMAN Z ET AL: "Study of thermal oxidation of NiO buffers on Ni-based tapes for superconductor substrates" , PHYSICA C, NORTH-HOLLAND PUBLISHING, AMSTERDAM, NL, VOL. 351, NR. 1, PAGE(S) 34-37 XP004230655 ISSN: 0921-4534 das ganze Dokument

## Beschreibung

### Technisches Gebiet

Die Erfindung betrifft ein ein- oder mehrschichtiges Metallband für die epitaktische Beschichtung mit einer biaxial texturierten Schicht und ein Verfahren zur Herstellung derartiger Metallbänder. Derartige Bänder können vorteilhaft als Trägerband für die Abscheidung biaxial texturierter Schichten aus YBa₂Cu₃Oₓ-Hochtemperatur-Supraleitermaterial verwendet werden.

### Stand der Technik

Es sind bereits Metallbänder auf der Basis von Ni, Cu und Ag bekannt, die sich für die epitaktische Beschichtung mit einer biaxial texturierten Schicht eignen (US 5 739 086; US 5 741 377; US 5 964 966; US 5 968 877). Sie werden durch Kaltwalzen mit einem Verformungsgrad über 95% und anschließende Rekristallisationsglühung hergestellt, wobei sich eine scharfe {001}<100> Textur (Würfeltextur) bildet.

Insbesondere an der Entwicklung von Substratmaterialien auf der Basis von Ni und Ag wird gegenwärtig weltweit intensiv gearbeitet (J. E. Mathis et al., Jap. J. Appl. Phys. **37**, 1998; T. A. Gladstone et al., Inst. Phys. Conf. Ser. No 167,1999).

Eines der entwickelten Substratmaterialien besteht aus einer Nickellegierung mit der Zusammensetzung Niₐ (Mo_{b},W_{c})_{d} Mₑ, worin M für ein oder mehrere Metalle mit Ausnahme von Ni, Mo oder W steht (DE 100 05 861 A1). Zur Herstellung dieses Materials wird zunächst auf schmelzmetallurgischem oder pulvermetallurgischem Wege oder durch mechanisches Legieren eine Legierung der genannten Zusammensetzung hergestellt und diese mit einer Warmumformung sowie einer nachfolgenden hochgradigen Kaltumformung zu Band verarbeitet. Dieses wird in reduzierender oder nichtoxidierender Atmosphäre einer rekristallisierenden Glühung unterworfen. Der Werkstoff besitzt im Vergleich zu technisch reinem Nickel eine höhergradige und thermisch stabilere Würfeltextur und ist als Unterlage für physikalisch-chemische Beschichtungen mit hochgradiger mikrostruktureller Ausrichtung einsetzbar.

Bei derartigen Materialien gibt es Bestrebungen, die Festigkeit des Materials zu steigern. Dies wird realisiert entweder durch Mischkristallhärtung, bei der eine Ni-Legierung mit typischerweise mehr als 5 % eines oder mehrerer Legierungselemente gewalzt und rekristallisiert wird, (US 5 964 966; G. Celentano et al., Int. Journal of Modern Physics B, **13**, 1999, S. 1029; R. Nekkanti et al., presentation at the Applied Supercond. Conf., Virginia Beach, Virginia, Sept. 17-22, 2000) oder durch Walzen und Rekristallisieren eines Verbundes aus Ni mit einem Material höherer Zugfestigkeit (T. Watanabe et al., Presentation at the Applied Supercond. Conf., Virginia Beach, Virginia, Sept. 17-22, 2000).

Bei der Mischkristallhärtung gibt es einen kritischen Legierungsgrad, oberhalb dessen sich die Würfeltextur nicht mehr ausbilden lässt. Dieses Phänomen ist für Messinglegierungen (Cu-Zn-Legierungen mit steigendem Zn-Gehalt) intensiv untersucht worden und scheint allgemeine Gültigkeit zu haben (H. Hu et al., Trans. AIME, 227, 1963, S. 627; G. Wassermann, J. Grewen: Texturen metallischer Werkstoffe, Springer-Verlag Berlin/Göttingen/Heidelberg). Da die Festigkeit stetig mit der Legierungskonzentration steigt, ist damit auch eine maximale Festigkeit verbunden. Die zweite Einschränkung ist die hohe Festigkeit des Materials bereits bei der Walzumformung. Dadurch treten bei dem notwendigerweise hohen Umformgrad sehr große Walzkräfte auf, wodurch zum einen erhöhte Ansprüche an das Walzwerk gestellt werden müssen und zum anderen es technisch schwieriger wird, die außerordentlich homogene Walzverformung durchzuführen, die für die Bildung der notwendigen hochgradigen Würfeltextur nötig ist.

Bei der Festigkeitssteigerung durch Walzen eines Verbundes aus einer Ni-, Cu- oder Ag-Legierung mit einem Material höherer Festigkeit gibt es ebenfalls das Problem der hohen Walzkräfte bei der starken Umformung eines sehr festen Werkstoffs. Auf Grund der Unterschiede in den mechanischen Eigenschaften der beiden, den Verbund bildenden Materialien treten beim Walzen Scherspannungen an der Grenzschicht und damit Inhomogenitäten in der Verformungsmikrostruktur auf, die die beim Rekristallisationsprozess erreichbare Würfeltexturqualität vermindern.

Eine Möglichkeit, die Festigkeit einer metallischen Matrix zu steigern, besteht auch in der bekannten Dispersionshärtung, bei der in der Matrix feindisperse, vorzugsweise keramische Partikel verwendet werden. Die Partikel können dabei auf pulvermetallurgischem Wege eingebracht oder durch eine exotherme Reaktion in situ erzeugt werden.

Auf diese Art hergestellte Werkstoffe sind jedoch nicht geeignet durch Walzen und Rekristallisieren zu einem dünnen, biaxial texturierten Band prozessiert zu werden. Zum einen weisen auch sie bereits beim Walzen eine sehr hohe Festigkeit auf und zum anderen konnte die Bildung einer für die Anwendung geeignete stark ausgeprägte Würfeltextur in einem dispersoidhaltigen Band bisher noch nicht nachgewiesen werden.

Neben dem Bemühen um Steigerung der Festigkeit gibt es Bestrebungen, unmagnetische Substrate zu entwickeln, um Hystereseverluste in Wechselstromanwendungen zu vermeiden (US 5 964 966). Des Weiteren gibt es Bestrebungen, das Substratband zur Stabilisierung der stromtragenden supraleitenden Schicht als Bypass zu verwenden (C. Cantoni et al., Presentation at the Applied Supercond. Conf., Virginia Beach, Virginia, Sept. 17-22, 2000). Um diese funktion zu realisieren, muss das Substrat eine möglichst hohe elektrische Leitfähigkeit besitzen.

Bekannt ist auch aus WO 99/17307 Al ein Substrat für Supraleiterschichten mit einer verbesserten Oxidationsbeständigkeit, bestehend aus einem Cu- oder Cu-Ni-Basiswerkstoff mit 0,1 - 25 at.-% festigkeitssteigernden Oxidbildnern, wobei dieser Oxidbildner auch zur Bildung von Oxiden durch innere Oxidation eingesetzt werden können. Derartige Oxide weisen eine Partikelgröße von 2 nm bis 1 µm im Substrat auf.
Die Substrate aus biaxial texturiertem Cu-Basiswerkstoff und Cu-Ni-Basiswerkstoff können mit einer oder mehreren Pufferschichten versehen sein und sind abschließend mit einer supraleitenden Schicht versehen.

### Darstellung der Erfindung

Der Erfindung liegt die Aufgabe zugrunde, ein Metallband zur epitaktischen Beschichtung mit einer biaxial texturierten Schicht zu schaffen, das eine hohe Zugfestigkeit, geringe magnetische Verluste und/oder eine hohe elektrische Leitfähigkeit aufweist. Der Erfindung liegt weiterhin die Aufgabe zugrunde, ein in der Durchführung unproblematisches Verfahren zur Herstellung derartiger Bänder zu schaffen.

Diese Aufgabe wird nach der Erfindung mit dem in den Patentansprüchen beschriebenen ein- oder mehrschichtigen Metallband und dem zugehörigen Herstellungsverfahren gelöst.

Erfindungsgemäß besteht das Metallband aus Ni, Cu, Ag oder deren Legierungen als Basiswerkstoff, wobei das einschichtige Metallband und beim mehrschichtigen Metallband wenigstens eine seiner Schichten 10 nm bis 5 µm große, festigkeitssteigernde Dispersoide aus Carbiden, Boriden, und/oder Nitriden mit einem Volumenanteil von 0,1 bis 5 % enthält, und wobei beim mehrschichtigen Metallband die Schichten einen Verbund bilden und wenigstens eine der Schichten dispersoidfrei ist und eine biaxiale Textur aufweist. Dispersoïde aus Oxiden Können vorhanden sein.

Die Schichten des mehrschichtigen Metallbandes können aus einem einheitlichen Basiswerkstoff bestehen oder sich wenigstens in einer der Schichten hinsichtlich des Basiswerkstoffs von den übrigen Schichten unterscheiden.

Gemäß einer zweckmäßigen Ausgestaltung besteht die dispersoidhaltige Schicht aus Cu, einer Cu-Legierung oder einer Ni-Legierung und die dispersoidfreie, biaxial texturierte Schicht aus Ni oder einer Ni-Legierung als Basiswerkstoff.

Die Carbid-Dispersoide können aus Cr₄C, Cr₇C₃, Cr₃C₂, B₄C, WC, Mo₂C, VC, NbC, TaC und/oder TiC bestehen.

Die Borid-Dispersoide können aus AlB₁₂, ZrB₂, Co₃B, W₂B₅ und/oder TiB₂ bestehen.

Die Oxid-Dispersoide können aus ZrO₂, TiO₂, Al₂O₃, ThO₂ und/oder CeO₂ bestehen.

Die Nitrid-Dispersoide aus BN, Si₃N₄, W₂N₃, ZrN, TiN und/oder CrN bestehen.

Zur Herstellung derartiger Bänder wird erfindungsgemäß ein Ausgangswerkstoff verwendet, der aus Ni, Cu, Ag oder deren Legierungen als Basiswerkstoff besteht und der 0,2 bis 5 Atom-% eines Zusatzes aus nitridierbaren, boridierbaren und/oder karbidierbaren Elementen enthält. Aus diesem Ausgangswerkstoff wird mittels Umformverfahren ein einschichtiges oder ein mehrschichtiges Band hergestellt, wobei für die Herstellung des mehrschichtigen Metallbandes für wenigstens eine seiner Schichten ein Basiswerkstoff ohne den vorbenannten Zusatz verwendet wird. Danach wird das Band zur Ausbildung einer Würfeltextur einer Rekristallisationsglühung unterworfen. Schließlich wird das Band einer Glühung unter einem Stickstoff-, Bor- oder Kohlenstoffpartialdruck ausgesetzt, der oberhalb des Gleichgewichtspartialdrucks der Nitride, Boride und Karbide der in der Legierung enthaltenen Zusatzelemente jedoch unterhalb des Gleichgewichtspartialdrucks von Nitriden, Boriden und Karbiden der Grundelemente Ni, Cu und Ag der Bandlegierung liegt. Eventuell Können Dispersoïde aus Oxiden in ähnlicher weise erzeugt werden.

In zweckmäßiger Weise wird ein Ausgangswerkstoff verwendet, der im Basiswerkstoff 1 bis 2 Atom-% des Zusatzes aus nitridierbaren, boridierbaren und/oder karbidierbaren Elementen und eventuell aus oxidierbaren Elementen enthält.

Im Falle einer Glühung des Bandes in Sauerstoff sollte das Band einer Temperatur im Bereich von 750 bis 1000°C ausgesetzt werden.

Mit dem erfindungsgemäßen Verfahren lassen sich in relativ einfacher Weise hochfeste, biaxial texturierte metallische Bänder aus Ni, Cu, Ag oder deren Legierungen herstellen. Dabei ist von besonderem Vorteil, dass die Bänder für die Prozessstufen der Umformung noch eine günstige niedrige Ausgangsfestigkeit aufweisen, da die festigkeitssteigernden Dispersoide erst bei der abschließenden Glühbehandlung im Band gebildet werden. Da zudem die Dispersoide erst nach der Rekristallisation entstehen, wird in vorteilhafter Weise die Entstehung der Würfeltextur nicht beeinträchtigt.

Der erfindungsgemäße Metallbandverbund besitzt sehr gute Eigenschaften hinsichtlich einer epitaktischen Beschichtung mit einer biaxial texturierten Schicht bei gleichzeitig hoher Zugfestigkeit. Die sehr guten Beschichtungseigenschaften ergeben sich dabei aus der Tatsache, dass die zur epitaktischen Beschichtung bestimmte Schicht des Metallbandes dispersoidfrei ist, wodurch keine oxidischen Teilchen an der Oberfläche dieser Schicht vorhanden sind, welche die Epitaxie stören können. Falls eine der Schichten des Verbundes aus Cu besteht, weist der Verbund eine hohe elektrische Leitfähigkeit auf. Der Substratverbund ist dann für eine Supraleiterschicht, welche auf der dispersionsfreien Schicht aufgebracht worden ist, als Bypass geeignet. Außerdem werden durch die Tatsache, dass Cu unmagnetisch ist, auch die Hystereseverluste im Falle von Wechselstromanwendungen gering gehalten.

### Wege zur Ausführung der Erfindung

Folgende Beispiele fallen nicht unter den beanspruchten Schutzumfang.

### Beispiel 1

Eine Legierung aus Ni mit 1 Atom-% Al wird erschmolzen. Das Gefüge wird durch Warmumformen zu einem Vierkant bei 1100°C homogenisiert und anschließend mit einem Verformungsgrad von 99,8 % zu einem Band der Dicke 40 µm gewalzt. Das Band wird anschließend in einem Rezipienten bei 900°C während einer Dauer von 30 Stunden unter definiertem O₂-Partialdruck geglüht. Der O₂-Partialdruck wird dabei durch die Beigabe einer Pulvermischung aus Ni und NiO im Rezipienten so eingestellt, dass der O₂-Partialdruck dem der Zersetzungsreaktion des NiO entspricht und deutlich oberhalb dem Gleichgewichtspartialdruck von Al₂O₃ liegt. Bei dieser Glühung werden aus dem im Band enthaltenen Al festigkeitssteigernde Al₂O₃-Dispersoide gebildet.

Das fertige Band weist eine hochgradige Würfeltextur auf. Die Streckgrenze des Bandes liegt bei 200 MPa, das ist 4,5mal so hoch wie die von reinem Ni.

### Beispiel 2

Eine Legierung aus Ni mit 1 Atom-% Al wird erschmolzen. Das Gefüge wird durch Warmumformen zu einem Vierkant bei 1100°C homogenisiert und anschließend mit einem Verformungsgrad von 99,8 % zu einem Band der Dicke 40 µm gewalzt. Das Band wird anschließend bei 900°C während einer Dauer von 30 Stunden in einem Vakuumofen unter einem konstanten O₂-Druck von 10⁻³ Pa geglüht. Bei dieser Glühung werden aus dem im Band enthaltenen Al festigkeitssteigernde Al₂O₃-Dispersoide gebildet.

Das Band weist eine hochgradige Würfeltextur auf. Die Streckgrenze liegt bei 180 MPa.

### Beispiel 3

Eine Legierung aus Ni mit 1,5 Atom-% Si wird erschmolzen. Das Gefüge wird durch Warmumformen zu einem Vierkant bei 1100°C homogenisiert und anschließend mit einem Verformungsgrad von 99,8 % zu einem Band der Dicke 40 µm gewalzt. Das Band wird anschließend in einem Rezipienten bei 900°C während einer Dauer von 30 Stunden unter definiertem O₂-Partialdruck geglüht. Der O₂-Partialdruck wird dabei durch die Beigabe einer Pulvermischung aus Ni und NiO im Rezipienten so eingestellt, dass der O₂-Partialdruck dem der Zersetzungsreaktion des NiO entspricht und deutlich oberhalb dem Gleichgewichtspartialdruck von SiO₂ liegt. Bei dieser Glühung werden aus dem im Band enthaltenen Si festigkeitssteigernde SiO₂-Dispersoide gebildet.

Das so hergestellte Band weist eine hochgradige Würfeltextur auf. Die Streckgrenze des Bandes liegt bei 200 MPa.

### Beispiel 4

Zunächst wird ein Verbundrohling hergestellt, bestehend aus einem Zylinder mit einem Durchmesser von 30 mm und einem den Zylinder umgebenden Rohr, das einen Außendurchmesser von 42 mm aufweist. Als Werkstoff für den Zylinder wird Ni mit 1,5 Atom-% Al verwendet. Das Rohr besteht aus reinem Ni.

Dieser Verbund wird zu einem Zylinder der Dicke 35 mm geschmiedet. Anschließend wird der Zylinder bei 1100°C zu einem Knüppel mit quaderförmigem Querschnitt umgeformt und bei einem Verformungsgrad von 99,8% zu einem Band der Dicke 40 µm gewalzt. Dieses wird bei 900°C für 30 Stunden geglüht. Der O₂-Partialdruck wird durch die Beigabe einer Pulvermischung aus Ni und NiO in den Rezipienten so eingestellt, dass der O₂-Partialdruck dem der Zersetzungsreaktion des NiO entspricht und deutlich oberhalb dem Gleichgewichtspartialdruck von Al₂O₃ liegt. Bei dieser Glühung werden aus dem Al im Ni-Kern des Bandes festigkeitssteigernde Al₂O₃-Dispersoide gebildet.

Das so hergestellte Band weist einen Ni-Kern auf, in dem die Al₂O₃-Dispersoide enthalten sind. Dieser Kern ist von einem Mantel aus reinem Nickel umgeben, der eine scharfe Würfeltextur aufweist und oxidpartikelfrei ist.

Die Streckgrenze des auf diese Weise hergestellten Bandes beträgt 180 MPa.

### Beispiel 5

Zunächst wird ein Verbundrohling hergestellt, bestehend aus einem Zylinder mit einem Durchmesser von 30 mm und einem den Zylinder umgebenden Rohr, das einen Außendurchmesser von 42 mm aufweist. Als Werkstoff für den Zylinder wird Cu mit 1,5 Atom-% Al verwendet. Das Rohr besteht aus reinem Ni.

Dieser Verbund wird zu einem Zylinder der Dicke 35 mm geschmiedet. Danach wird der Zylinder bei 1100°C homogenisiert und anschließend mit einem Verformungsgrad von 99,8% zu einem Band der Dicke 40µm gewalzt. Dieses wird bei 900°C für 30 Stunden geglüht. Der O₂-Partialdruck wird durch die Beigabe einer Pulvermischung aus Ni und NiO in den Rezipienten so eingestellt, dass der O₂-Partialdruck dem der Zersetzungsreaktion des NiO entspricht und deutlich oberhalb dem Gleichgewichtspartialdruck von Al₂O₃ liegt. Bei dieser Glühung werden aus dem Al im Cu-Kern des Bandes festigkeitssteigernde Al₂O₃-Dispersoide gebildet.

Das so hergestellte Band weist einen Cu-Kern auf, in dem die Al₂O₃-Dispersoide enthalten sind. Dieser Kern ist von einem Mantel aus reinem Nickel umgeben, der eine scharfe Würfeltextur aufweist und oxidpartikelfrei ist.

Die Streckgrenze des auf diese Weise hergestellten Bandes beträgt 160 MPa.

### Beispiel 6

Ein Verbundrohling, bestehend aus einem Zylinder der Legierung Ni_{93,5}W₅Al_{1,5} mit einem Durchmesser von 30 mm und einem den Zylinder umgebenden Rohr aus der Legierung Ni₉₅W₅ mit einem Außendurchmesser von 42 mm, wird zunächst zu einem Zylinder der Dicke 35 mm geschmiedet. Dieser wird bei 1100°C homogenisiert und anschließend mit einem Verformungsgrad von 99,8% zu einem Band der Dicke 40 µm gewalzt. Dieses wird bei 900°C für 30 Stunden geglüht. Der O₂-Partialdruck wird durch die Beigabe einer Pulvermischung aus Ni und NiO in den Rezipienten so eingestellt, dass der O₂-Partialdruck dem der Zersetzungsreaktion des NiO entspricht und deutlich oberhalb dem Gleichgewichtspartialdruck von Al₂O₃ liegt. Bei dieser Glühung werden aus dem Al im Ni_{93,5}W₅Al_{1,5}-Kern des Bandes festigkeitssteigernde Al₂O₃-Dispersoide gebildet.

Das hergestellte Band weist einen Kern aus einer NiW-Legierung auf, in dem die Al₂O₃-Dispersoide enthalten sind. Dieser Kern ist von einer Hülle aus reinem Nickel umgeben, die eine scharfe Würfeltextur aufweist und oxidpartikelfrei ist.

Die Streckgrenze des auf diese Weise hergestellten Bandes beträgt 300 MPa.

## Patentansprüche

1. Ein- oder mehrschichtiges Metallband für die epitaktische Beschichtung mit einer biaxial texturierten Schicht, bei dem das Metallband aus Ni, Cu, Ag oder deren Legierungen als Basiswerkstoff besteht, wobei das einschichtige Metallband und beim mehrschichtigen Metallband wenigstens eine seiner Schichten 10 nm bis 5 µm große, festigkeitssteigernde Dispersoide aus Carbiden, Boriden und/oder Nitriden mit oder ohne Oxiden mit einem Volumenanteil von 0,1 bis 5 % enthält, und wobei beim mehrschichtigen Metallband die Schichten einen Verbund bilden und wenigstens eine der Schichten dispersoidfrei ist und eine biaxiale Textur aufweist.

2. Metallband nach Anspruch 1, **dadurch gekennzeichnet, dass** die Schichten des mehrschichtigen Metallbandes aus einem einheitlichen Basiswerkstoff bestehen oder sich wenigstens eine der Schichten hinsichtlich des Basiswerkstoffs von den übrigen Schichten unterscheidet.

3. Metallband nach Anspruch 1, **dadurch gekennzeichnet, dass** die dispersoidhaltige Schicht aus Cu oder einer Cu-Legierung und die dispersoidfreie, biaxial texturierte Schicht aus Ni oder einer Ni-Legierung als Basiswerkstoff besteht.

4. Metallband nach Anspruch 1, **dadurch gekennzeichnet, dass** die Carbid-Dispersoide aus Cr₄C, Cr₇C₃, Cr₃C₂, B₄C, WC, Mo₂C, VC, NbC, TaC und/oder TiC bestehen.

5. Metallband nach Anspruch 1, **dadurch gekennzeichnet, dass** die Borid-Dispersoide aus AlB₁₂, ZrB₂, Co₃B, W₂B₅ und/oder TiB₂ bestehen.

6. Metallband nach Anspruch 1, **dadurch gekennzeichnet, dass** Oxid-Dispersoide aus ZrO₂, TiO₂, Al₂O₃, ThO₂ und/oder CeO₂ vorhanden sind.

7. Metallband nach Anspruch 1, **dadurch gekennzeichnet, dass** die Nitrid-Dispersoide aus BN, Si₃N₄, W₂N₃, ZrN, TiN und/oder CrN bestehen.

8. Verfahren zur Herstellung eines ein- oder mehrschichtigen Metallbandes nach einem der Ansprüche 1 bis 7, bei dem ein Ausgangswerkstoff verwendet wird, der aus Ni, Cu, Ag oder deren Legierungen als Basiswerkstoff besteht und der 0,2 bis 5 Atom-% eines Zusatzes aus nitridierbaren, boridierbaren und/oder karbidierbaren Elementen mit oder ohne oxidierbaren Elementen enthält, dass aus diesem Ausgangswerkstoff mittels Umformverfahren ein einschichtiges oder ein mehrschichtiges Band hergestellt wird, wobei für die Herstellung des mehrschichtigen Metallbandes für wenigstens eine seiner Schichten ein Basiswerkstoff ohne den vorbenannten Zusatz verwendet wird, dass danach das Band zur Ausbildung einer Würfeltextur einer Rekristallisationsglühung unterworfen wird, und dass schließlich das Band einer Glühung unter einem Stickstoff-, Bor- oder Kohlenstoffpartialdruck und eventuell einem Sauerstoffpartialdruck ausgesetzt wird, der oberhalb des Gleichgewichtspartialdrucks der Nitride, Boride und Karbide und eventuell vorhandener Oxide der in der Legierung enthaltenen Zusatzelemente jedoch unterhalb des Gleichgewichtspartialdrucks von Nitriden, Boriden, Karbiden und eventuell Oxiden der Grundelemente Ni, Cu und Ag der Bandlegierung liegt.

9. Verfahren nach Anspruch 8, **dadurch gekennzeichnet, dass** ein Ausgangswerkstoff verwendet wird, der in Ni, Cu, Ag oder deren Legierungen als Basiswerkstoff 1 bis 2 Atom-% eines Zusatzes aus nitridierbaren, boridierbaren und/oder karbidierbaren und eventuell oxidierbaren Elementen enthält.

10. Verfahren nach Anspruch 8, **dadurch gekennzeichnet, dass** das Band im Falle einer Glühung in Sauerstoff einer Temperatur im Bereich von 750 bis 1000°C ausgesetzt wird.

## Claims

1. Single-layer or multilayer metal strip for epitaxial coating with a biaxially textured layer, wherein the metal strip consists of Ni, Cu, Ag or alloys thereof as base material, the single-layer metal strip, or in the case of the multilayer metal strip at least one of its layers, containing strength-enhancing dispersoids of carbides, borides and/or nitrides, with or without oxides, of a size of 10 nm to 5 µm, forming from 0.1 to 5% by volume, and in the case of the multilayer metal strip the layers forming a composite and at least one of the layers being dispersoid-free and having a biaxial texture.

2. Metal strip according to Claim 1, **characterized in that** the layers of the multilayer metal strip consist of a uniform base material, or the base material of at least one of the layers differs from that of the other layers.

3. Metal strip according to Claim 1, **characterized in that** the dispersoid-containing layer consists of Cu or a Cu alloy, and the dispersoid-free, biaxially textured layer consists of Ni or a Ni alloy, as base material.

4. Metal strip according to Claim 1, **characterized in that** the carbide dispersoids consist of Cr₄C, Cr₇C₃, Cr₃C₂, B₄C, WC, Mo₂C, VC, NbC, TaC and/or Tic.

5. Metal strip according to Claim 1, **characterized in that** the boride dispersoids consist of AlB₁₂, ZrB₂, Co₃B, W₂B₅ and/or TiB₂.

6. Metal strip according to Claim 1, **characterized in that** oxide dispersoids of ZrO₂, TiO₂, Al₂O₃, ThO₂ and/or CeO₂ are present.

7. Metal strip according to Claim 1, **characterized in that** the nitride dispersoids consist of BN, Si₃N₄, W₂N₃, ZrN, TiN and/or CrN.

8. Process for producing a single-layer or multilayer metal strip according to one of Claims 1 to 7, which uses a starting material that consists of Ni, Cu, Ag or alloys thereof as base material and contains 0.2 to 5 atomic % of an addition of nitridable, boridable and/or carbidable elements with or without oxidizable elements, wherein a single-layer or multilayer strip is produced from this starting material by forming processes, in which process, for the production of the multilayer metal strip, a base material without the abovementioned addition is used for at least one of its layers, wherein the strip is then subjected to a recrystallization anneal in order to form a cube texture, and wherein finally the strip is subjected to an anneal under a nitrogen, boron or carbon partial pressure and optionally an oxygen partial pressure which is above the equilibrium partial pressure of the nitrides, borides and carbides and any oxides which are present in the additional elements contained in the alloy, but below the equilibrium partial pressure of nitrides, borides, carbides and any oxides of the base elements Ni, Cu and Ag of the strip alloy.

9. Process according to Claim 8, **characterized by** the use of a starting material which in Ni, Cu, Ag or alloys thereof as base material contains 1 to 2 atomic % of an addition of nitridable, boridable and/or carbidable and optionally oxidizable elements.

10. Process according to Claim 8, **characterized in that** in the case of an anneal in oxygen, the strip is subjected to a temperature in the range from 750 to 1000°C.

## Revendications

1. Feuillard métallique en une ou plusieurs couches, destiné à un revêtement par épitaxie et qui présente une couche à texture biaxiale, le feuillard métallique présentant comme matériau de base du Ni, du Cu, de l'Ag ou leurs alliages, le feuillard métallique en une couche et, au cas où le feuillard métallique est en plusieurs couches, au moins une des couches du feuillard contenant des dispersoïdes de renforcement de la résistance mécanique d'une taille de 10 nm à 5 µm, en carbures, borures et/ou nitrures, avec ou sans oxydes, à une teneur en volume de 0,1 à 5 %, et dans lequel lorsque le feuillard métallique est en plusieurs couches, les couches forment un composite et au moins l'une des couches est exempte de dispersoïdes et présente une texture biaxiale.

2. Feuillard métallique selon la revendication 1, **caractérisé en ce que** les couches du feuillard métallique en plusieurs couches sont constituées d'un même matériau de base ou **en ce que** le matériau de base d'au moins une des couches est différent de celui des autres couches.

3. Feuillard métallique selon la revendication 1, **caractérisé en ce que** le matériau de base de la couche qui contient des dispersoïdes est le Cu ou un alliage de Cu et **en ce que** le matériau de base de la couche exempte de dispersoïdes et texturé biaxialement est en Ni ou un alliage de Ni.

4. Feuillard métallique selon la revendication 1, **caractérisé en ce que** les dispersoïdes de carbures sont constitués de Cr₄C, Cr₇C₃, Cr₃C₂, B₄C, WC, Mo₂C, VC, NbC, TaC et/ou de TiC.

5. Feuillard métallique selon la revendication 1, **caractérisé en ce que** les dispersoïdes de borures sont constitués de AlB₁₂, ZrB₂, Co₃B, W₂B₅ et/ou de TiB₂.

6. Feuillard métallique selon la revendication 1, **caractérisé en ce qu'**il présente des dispersoïdes d'oxydes constitués de ZrO₂, TiO₂, Al₂O₃, ThO₂ et/ou de CeO₂.

7. Feuillard métallique selon la revendication 1, **caractérisé en ce que** les dispersoïdes de nitrures sont constitués de BN, Si₃N₄, W₂N₃, ZrN, TiN et/ou de CrN.

8. Procédé de fabrication d'un feuillard métallique en une ou plusieurs couches selon l'une des revendications 1 à 7, dans lequel on utilise un matériau de départ dont le matériau de base est du Ni, du Cu, de l'Ag ou leurs alliages et qui contient de 0,2 à 5 % atomiques d'un additif constitué d'éléments nitrurables, borurables et/ou carburables, avec ou sans éléments oxydables, en ce qu'à partir de ce matériau de départ, on prépare par une opération de façonnage un feuillard en une couche ou en plusieurs couches, et dans lequel on utilise pour la préparation d'au moins une des couches du feuillard métallique en plusieurs couches un matériau de base qui ne présente pas l'additif mentionné plus haut, le feuillard subissant ensuite un recuit de cristallisation pour y former une texture cubique, le feuillard subissant ensuite un recuit sous pression partielle d'azote, de bore ou de carbone et éventuellement d'une pression partielle d'oxygène supérieure à la pression partielle d'équilibre des nitrures, borures et carbures et des oxydes éventuellement présents des éléments d'addition contenus dans l'alliage, mais inférieure à la pression partielle d'équilibre des nitrures, borures et carbures et éventuellement des oxydes des éléments de base Ni, Cu et Ag de l'alliage du feuillard.

9. Procédé selon la revendication 8, **caractérisé en ce que** l'on utilise un matériau de départ qui contient dans le matériau de base de Ni, Cu, Ag ou de leurs alliages de 1 à 2 % atomiques d'un additif constitué d'éléments nitrurables, borurables et/ou carburables, et éventuellement oxydables.

10. Procédé selon la revendication 8, **caractérisé en ce que**, lorsque le feuillard est recuit dans l'oxygène, il est exposé à une température comprise dans la plage de 750 à 1 000°C.
